# EUROPEAN PATENT SPECIFICATION

(11) **EP 0 308 166 B1**
(45) Date of publication and mention of the grant of the patent: **04.08.1993**
(21) Application number: 88308427.9
(22) Date of filing: 13.09.1988
(51) Int. Cl.: H01L 21/20, H01L 21/265

(54) **Polycrystalline film formation**
Herstellung einer polykristallinen Schicht
Formation d'une couche polycristalline

(30) Priority: 18.09.1987 US 98259
(43) Date of publication of application: 22.03.1989
(73) Proprietor: XEROX CORPORATION, Rochester New York 14644 (US)
(72) Inventor: Chiang, Anne, Cupertino California 95014 (US); Wu, I-Wei, San Jose California 95131 (US); Huang, Tiao-Yuan, Cupertino California 95014 (US)
(74) Representative: Johnson, Reginald George

(56) References cited:
- US-A- 4 509 990
- PATENT ABSTRACTS OF JAPAN, vol. 10, no. 384 (E-466)[2441], 23rd December 1986; & JP-A-61 174 621
- JAPANESE JOURNAL OF APPLIED PHYSICS, vol. 25, no. 2, February 1986, pages L121-L123, Tokyo, JP; T. NOGUCHI et al.: "Low temperature polysilicon super-thin-film transistor (LSFT)"
- BEAM-SOLID INTERACTIONS AND TRANSIENT PROCESSES SYMPOSIUM, Boston, 1st-4th December 1986, pages 319-325, Materials Research Society; J.A. ROTH et al.: "Effects of impurities on the kinetics of nucleation and growth in amorphous silicon"

## Description

This invention relates to a method of forming large grain size polycrystalline films particularly, but not exclusively, films of polycrystalline silicon.

Amorphous silicon has been used extensively in solar cells and display applications for a number of years. More recently, a new field of electronics has been growing, based upon the formation of large area circuits of amorphous silicon material upon large, inexpensive, transparent, glass substrates. The enabling technology is the ability to deposit thin films of this semiconducting material over large areas and the processing of circuits using techniques similar to conventional IC processing. Examples of such large area electronics are to be found described in US-A-4,584,592 entitled "Marking Head for Fluid Jet Assisted Ion Projection Imaging Systems", and US-A-4,588,997 entitled "Electrographic Writing Head". In both of these patents there is taught a large area marking head array including a large number of input or output transducers connected through thin film transistor (TFT) switches to a relatively small number of external array driver lines, all fabricated upon a single, large area substrate.

Although the amorphous silicon .TFTs have met with considerable success in their applications, their extremely low carrier mobilities (typically below 1 cm²/V-s) have limited their current driving capacity and ultimately device operating speed. On the other hand, polycrystalline silicon TFTs are expected to achieve higher carrier mobility, on the order of 20 to 100 cm²/V-s and perhaps even higher speeds. From the perspective of device operating speed, this material would appear to present an attractive replacement for amorphous silicon in many applications.

A shortcoming of as-deposited polycrystalline films is their usual small grains which adversely effect carrier mobility. It is known that increasing grain size so as to reduce the number and detrimental effect of grain boundaries in the film will increase carrier mobility and enhance device performance. Usually grain size enhancement has required high temperature processing (>1000°C) which would not be satisfactory for large area electronic arrays upon the desirable, low cost, glass substrates. For example, Corning 7059® is a good, inexpensive, mass produced glass having a high degree of flatness, whose anneal point is 630°C. It would not be prudent for any processing thereon to exceed 600°C for an extended period of time. Recently the literature has included lower temperature techniques for enlarging grains in polycrystalline silicon thin films. The following two papers are representative of the current state of this art: "Low Temperature Polysilicon Super Thin-Film Transistor (LSFT)" by Noguchi *et al,* published in Japanese Journal of Applied Physics, Part 2 Letters, Vol. 25, No. 2, February 1986 at pp L121-L123 and "Comparison of Thin Film Transistors Fabricated at Low Temperatures (<600°C) on As-Deposited and Amorphized-Crystallized Polycrystalline Si" by Kung *et al,* published in Journal of Applied Physics 61(4), 15 February 1987 at pp 1638-1642.

The methods described in both of the above-identified papers include amorphizing the polycrystalline film by silicon ion implantation and subsequently recrystallizing the film with a low temperature (<600°C) anneal. It is reported in the Noguchi *et al* article that the ion implantation energy is peaked at about the mid-film depth but the location of the implantation energy peak is not discussed in the Kung *et al* article. In both of the described methods, the effect of ion implantation is to destroy the crystalline lattice structures so as to convert the polycrystalline film to an amorphous form. By selecting the proper ion implantation angle, relative to normal incidence, the implantation will amorphize most of the crystalline grains in the film. Those random crystallites which were aligned with the ion beam will survive and will grow during the subsequent annealing step. Since the density of the surviving crystallites is greatly diminished, each will grow virtually unimpeded and will continue to enlarge until it meets a neighboring grain.

In each of the aforementioned references, the starting material has been a polycrystalline silicon film which has been nearly completely amorphized by ion implantation. The technique of amorphizing and recrystallizing a semiconductor layer, utilizing ion implantation also has been disclosed in the following patents: US-A-4,463,492 (Maeguchi); US-A 4,509,990 (Vasudev); and US-A-4,588,447. It should be understood that the ion implantation step of this known technique results in a film having a predetermined number of grain growth sites.

According to the present invention there is provided a method of forming large grain polycrystalline films, including the steps of depositing a layer of amorphous semiconductor. material upon an insulating substrate, such as glass, implanting ions into the film at an implant energy and dosage sufficient to disrupt the interface between the amorphous layer and the insulating substrate, and subsequently annealing the implanted film to cause its crystallization. By the appropriate selection of the ion species, implant energy and dosage relative to the thickness and type of the amorphous layer and its underlying substrate, sufficient energy will be directed at the intertace to impede the nucleation process during subsequent annealing and allowing the growth of large grains.

We have found that it is desirable to use amorphous silicon as a starting material because of its absence of grain growth sites, its lower deposition temperature, compatible with low cost glasses, and its extremely smooth, as-deposited, surface which is a factor in increasing carrier mobility across device channel regions fabricated in the film. An advantage of this invention is that it provides a low temperature method for fabricating device grade, large grain, thin film polycrystalline silicon films upon a low cost, insulating, glass substrate. Nucleation in the silicon film is retarded by the ion implantation step and then nucleation occurs randomly from the bottom surface of the amorphous film during the subsequent thermal annealing step, resulting in more extended grain growth.

An embodiment of the invention will now be described, by way of example, with reference to the accompanying drawings, wherein:
FIG. 1 is a schematic cross-sectional view of an insulator substrate with an amorphous silicon film thereon,
FIG. 2 is a schematic cross-sectional view of the FIG. 1 composite film structure being ion implanted in accordance with the invention,
FIG. 3 is a schematic cross-sectional view of the FIG. 1 structure showing the disruption of the interface caused by the ion implantation,
FIG. 4 illustrates representative curves showing grain size as a function of annealing time for as-deposited and implanted LPCVD (low pressure chemical vapor deposition) amorphous silicon films,
FIG. 5 illustrates representative curves showing grain size as a function of annealing time for as-deposited and implanted PECVD (plasma enhanced chemical vapor deposition) amorphous silicon films,
FIG. 6 is an idealized graphic representation of the optimal implanted ion density distribution relative to the interface of the composite film structure for grain size enhancement,
FIG. 7 illustrates experimental curves showing grain size as a function of implant dose for an implant concentration peak located slightly shallower than the interface between the LPCVD amorphous film and its substrate,
FIG. 8 illustrates experimental curves showing grain size as a function of implant dose for an implant concentration peak at the interface, and
FIG. 9 illustrates experimental curves showing grain size as a function of implant dose for an implant concentration peak located slightly deeper than the interface.
FIG. 10 illustrates the temperature dependence of nucleation rate and growth rate of crystalline grains in the random crystallization process.

In accordance with the present invention it is possible to start out with a large area (perhaps page size) amorphous insulating substrate upon which is deposited a thin amorphous semiconductor layer. Then the amorphous semiconductor layer is ion implanted in a controlled manner so as to disrupt the interface and retard nucleation during a subsequent annealing step. Since we start with an amorphous film we are assured that there are no nuclei present in its as-deposited state. During thermal annealing, random temperature dependent nucleation from the interface occurs, resulting in some embryos of nuclei gaining enough energy over time to reach critical size and become nuclei. These continue to grow into larger crystalline grains until they encounter other growing grains which will mutually impede their further growth. Our process of retarded random nucleation is to be distinguished from the well known recrystallization processes wherein a crystalline semiconductor is first selectively amorphized and is then recrystallized from the few undestroyed nuclei. In the known process, wherein there are a predetermined number of nuclei at the initiation of the annealing step, the final grain size is limited by the density of these nuclei.

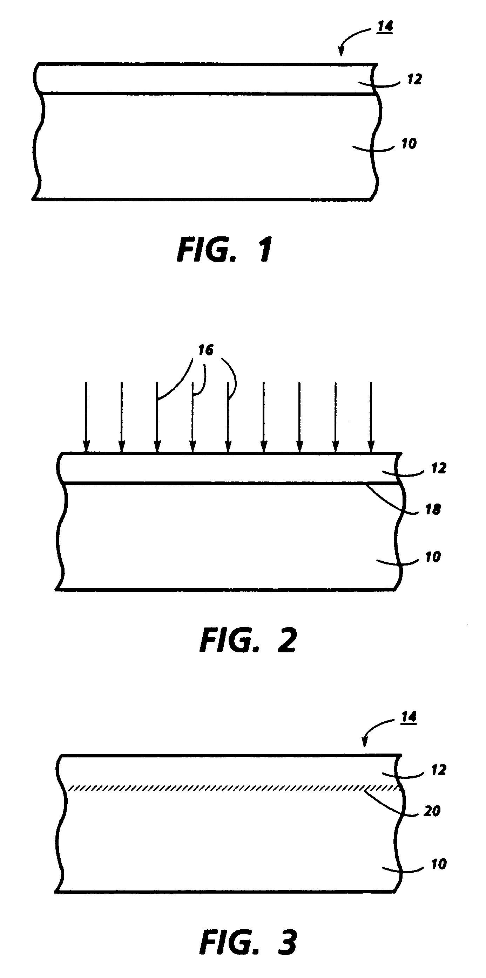

In Figure 1 there is shown a glass substrate 10 upon which a thin layer 12 of amorphous silicon, about 100nm thick has been deposited during the first step of our process to form a composite structure 14. Deposition may be accomplished by LPCVD (low pressure chemical vapor deposition), by PECVD (plasma enhanced chemical vapor deposition) or by any other suitable method. A preferred glass is Corning 7059® which, since it has an anneal point of 630°C should not be processed at a temperature exceeding 600°C for an extended period of time. Typically, we deposited the amorphous silicon film in a LPCVD reactor via the pyrolysis of pure silane (SiH₄), introduced at a flow rate of 100 sccm, at a temperature of 575°C and a pressure of 0.47hPa (0.35 Torr). When deposition was accomplished by PECVD, typically we deposited the amorphous silicon film in an RF plasma reactor via the decomposition of pure silane, introduced at a flow rate 68 sccm, at a temperature of 250°C, a pressure of 0.37hPa (0.28 Torr) and an RF power of 3 Watts.

After deposition the composite structure 14 is placed in a known particle accelerator where it is subjected to controlled ion implantation, as schematically illustrated by arrows 16 in Figure 2. It is the purpose of the implantation to bombard the interface with properly chosen ion acceleration energy so as to disrupt the well defined interface 18 between the silicon layer 12 and the silicon dioxide substrate 10 and create an ill-defined interface 20, as shown in Figure 3. This may be accomplished optimally by locating the position of the peak of the implanted ion concentration depth profile (identified as projected range Rₚ) in the vicinity of the interface 18. To form an undoped silicon layer, we implant with Si + ions. Of course, it is well understood that if it is desired to dope the semiconductor layer the implantation step may be accomplished with ions of phosphorus or other electrically active elements such as, for example, boron, arsenic or antimony, while achieving substantially the same grain size enhancement results.

Subsequent to the implantation step, the composite layer 14 is subjected to thermal annealing at 600°C for a length of time necessary to provide the crystallization kinetics to grow grains to completion. By comparison with the results we have obtained, it should be noted that as-deposited (non-implanted) amorphous silicon films, when annealed at 600°C, immediately begins to crystallize from the interface, indicating that nucleation initiates immediately. On the other hand, ion implantation of amorphous silicon films, controlled in accordance with our process, alters the microstructure of the interface so that it is energetically less favorable to nucleate during the thermal activation step. After a retardation period, grains nucleate from the interface and grow to a much larger final grain size.

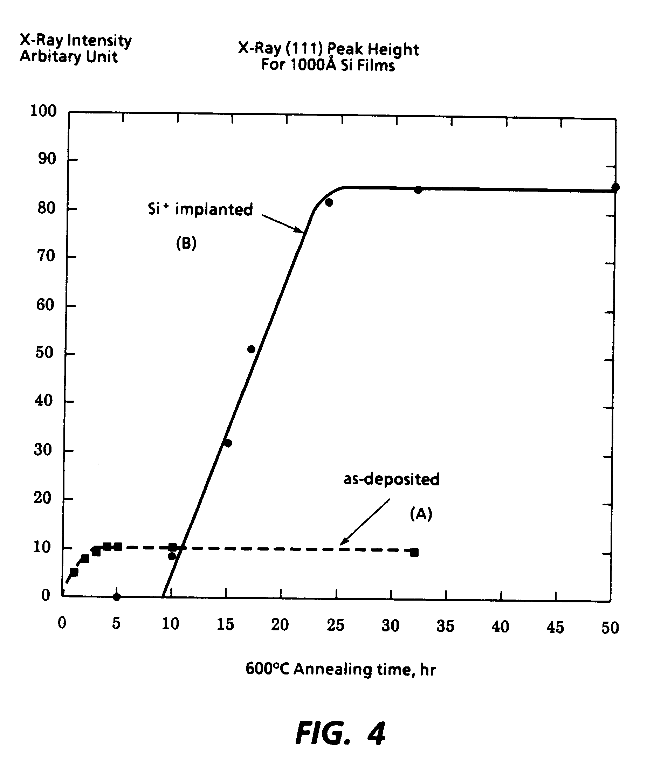

In Figure 4, the difference between the crystallization kinetics in as-deposited and deep implanted LPCVD amorphous silicon may readily be seen. Annealing time is plotted against X-ray diffraction intensity during annealing (a readily obtained measurement which correlates with grain size). Curve A represents an as-deposited (un-implanted) amorphous silicon layer. It is important to note that crystal growth begins immediately, starting at the interface, with maximum grain size being on the order of 0.1 to 0.2 micrometers. By dramatic contrast, curve B represents an amorphous silicon layer deep implanted with Si + ions in accordance with our invention, in which there is a retardation (incubation) period of about ten hours during which no crystal growth occurs, followed by the rapid growth of large area grains. We have been able to grow large grain polycrystalline films with grains of about 2 to 3 micrometers in size.

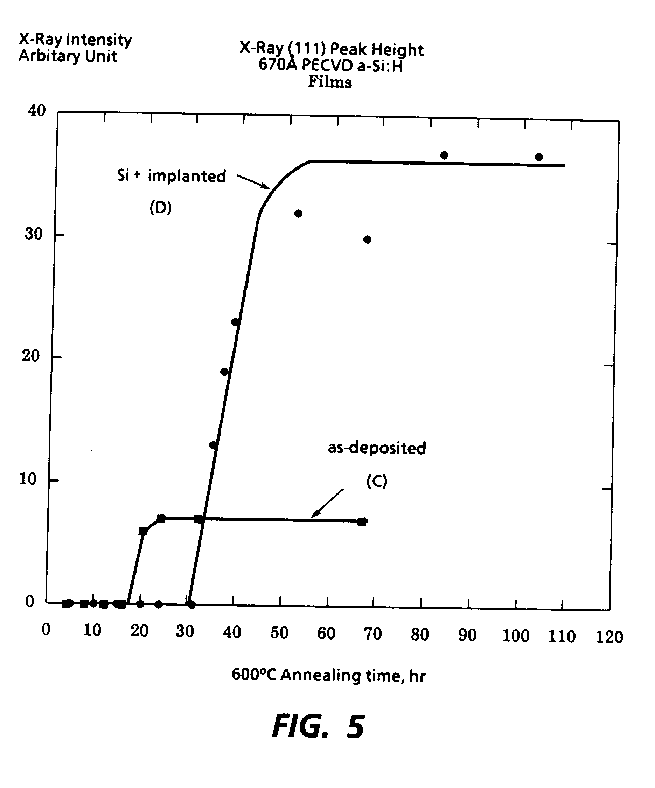

Similarly, in Figure 5, the difference between the crystallization kinetics in as-deposited (curve C) and deep implanted (curve D) PECVD amorphous silicon may readily be seen. In this case, the as-deposited (un-implanted) film exhibits a retardation of nucleation for about sixteen hours when annealed at 600°C. However, after deep ion implantation similar results appear, namely, retardation is prolonged and the maximum grain size is increased.

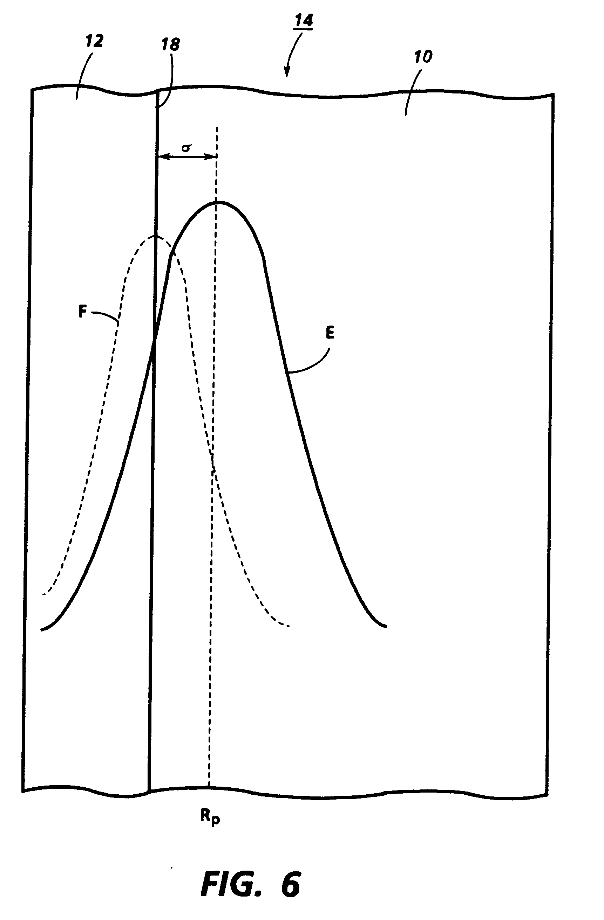

In Figure 6, we illustrate implantation ion concentration depth profile E superimposed upon the composite film structure 14, under optimum interface disruption conditions (Rₚ ≈ t_{Si} + 1σ, where Rₚ is the peak of the implant profile, t_{Si} is the thickness of the amorphous silicon film, and σ is a standard deviation of the implant profile). It is well known that the peak of the damage profile (maximum deposited kinetic energy ion concentration depth profile) lags the peak of the implant profile (Rₚ) by about one standard deviation as reported in "Recoil Contribution to Ion-Implantation Energy-Deposition Distributions" by Brice, published in Journal of Applied Physics, Vol. 46, No. 8, August 1975. Therefore, curve F of Figure 6 clearly shows that the maximum disruption occurs at the interface when the peak of the implant concentration profile (Rₚ) is located about one standard deviation beyond the interface 18, into the substrate 10.

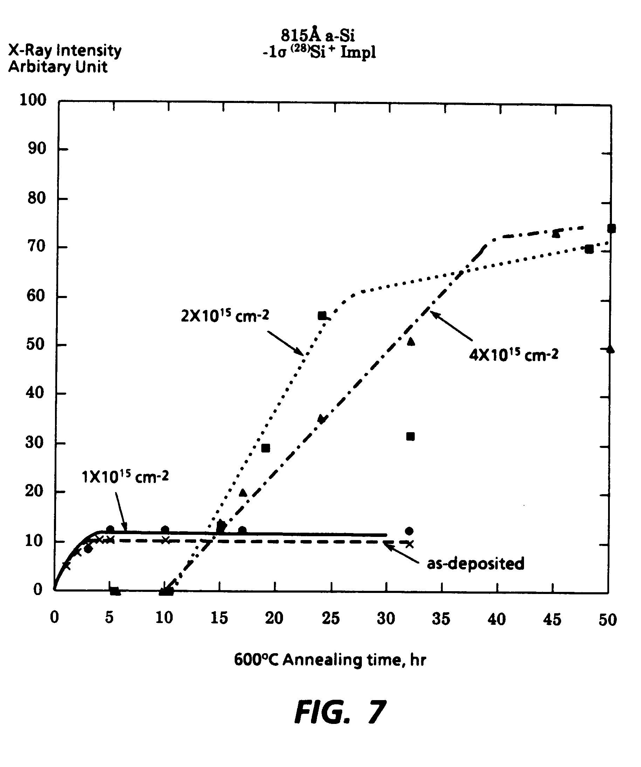

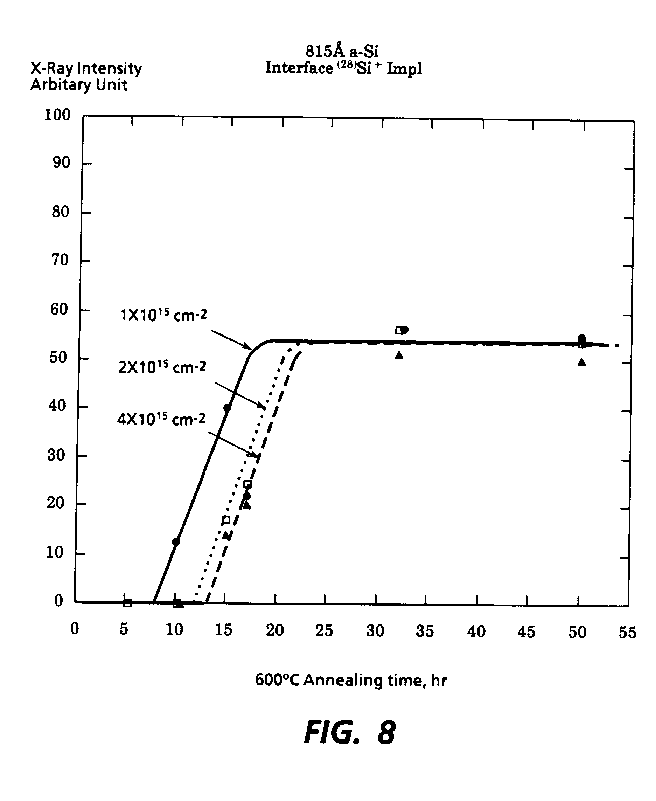

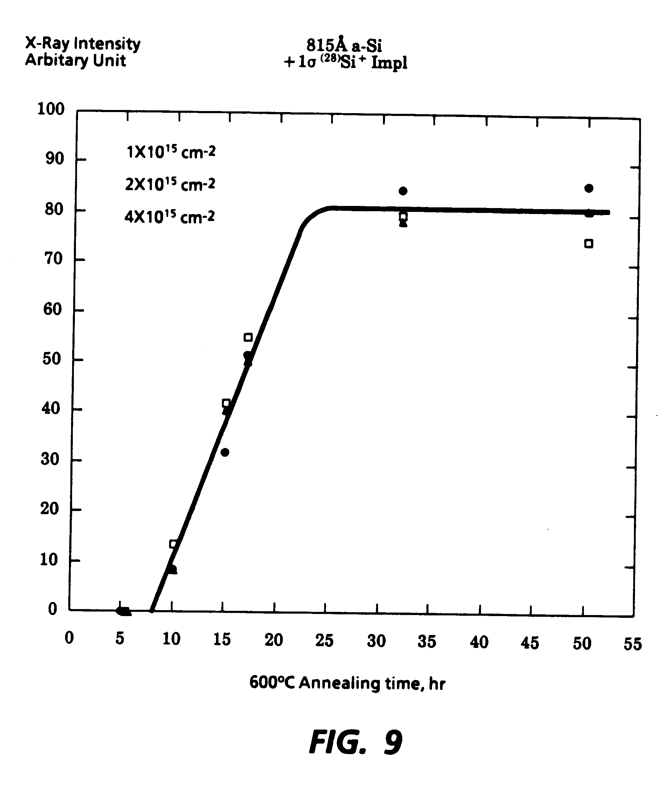

Figures 7, 8 and 9 show the effect of implant energy and dose on grain growth kinetics as indicated by X-ray diffraction intensity for a 81.5nm LPCVD amorphous silicon film annealed at 600°C. In Figure 7, the ion species ²⁸Si + implant slightly shallower than the interface 18, within the amorphous silicon film 12 (Rₚ = t_{Si} - 1σ), is achieved with an implant energy of 40KeV. A strong dose dependence may be observed. In fact, the film with the smallest dose of 1x10¹⁵ cm-² behaves virtually the same as the as-deposited film. When a sufficiently large dose is provided (2x10¹⁵ and 4x10¹⁵) crystallization retardation and large grain growth is obtained. Although not shown, we have observed that the crystallization kinetics of a film implanted with a dose of 2x10¹⁵ cm-² at mid-film (Rₚ = ½t_{Si}) is identical to that of an as-deposited film. In Figure 8, the ²⁸Si + implant at the interface (Rₚ = t_{Si}) is achieved with an implant energy of 58KeV. Each of the doses used is sufficiently high to obtain large grain growth. The best and most consistent results were observed in Figure 9, wherein the ²⁸Si + implant slightly deeper than the interface (Rₚ = t_{Si} + 1σ), into the SiO₂ substrate 10, is achieved with an implant energy of 92KeV. The nucleation retardation time remains about the same but the grain size is substantially larger. It should be noted that all the doses result in the same retardation and grain size, therefore it can be concluded that the disruption threshold has been exceeded.

When the amorphous silicon film is deposited upon the substrate, there is a molecularly sharp interface between the two layers, with pure Si on one side and SiO₂ on the other. It is our intent to add sufficient kinetic energy to disturb and modify this sharp interface, by ion mixing, in order to alter the energy requirement for nucleation at the interface. The following explanation is our present understanding of the mechanism of grain size enhancement by deep ion implantation. Ion energy provided in the vicinity of the interface breaks the SiO₂ bonds in the substrate adjacent the interface, causing oxygen atoms to be recoiled into the silicon film. The presence of recoiled oxygen within the silicon film is believed to impede the nucleation process by changing the volumetric free energy of the amorphous silicon. In other words, we suppress the nucleation process by modifying the interface so that it is energetically less favorable to nucleate. After ion implantation, the atoms must wait in a highly disrupted state for sufficient thermal energy to be provided to rearrange themselves into a crystal lattice orientation. When the thermal annealing is initiated, the atoms begin to vibrate more rapidly and seek to align themselves into an orderly lattice. As they randomly begin to be aligned, they first form small clusters, or embryos, which have a tenuous lifetime and require further energy to continue to grow to the size of a critical nucleus. Once the critical nucleus is formed, the crystal will start to grow, as long as thermal energy is supplied, until its further growth is impeded by competing growth of an adjacent crystal.

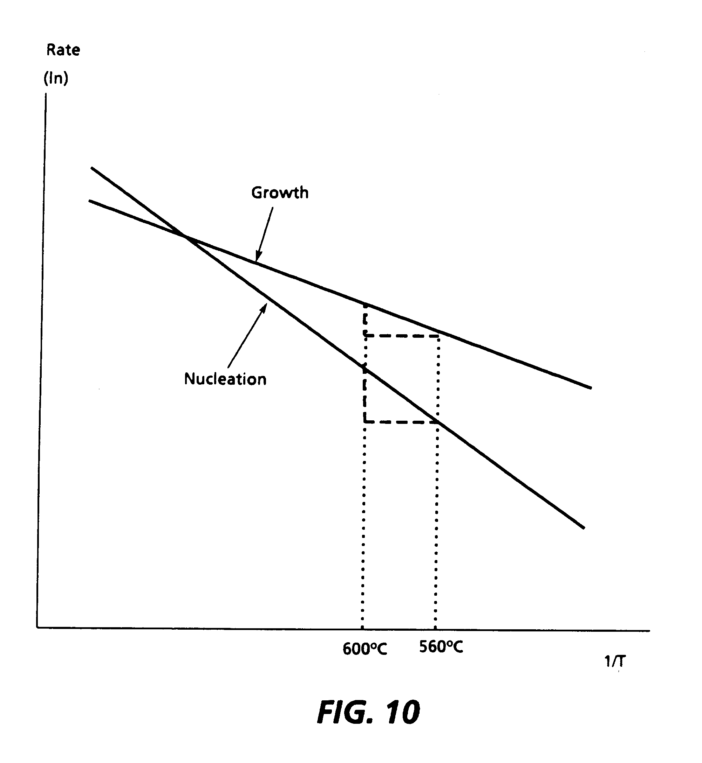

Our random nucleation process can be controlled to obtain larger grains by reducing the annealing temperature. In Figure 10 we have schematically plotted the natural log (In) of the nucleation rate (N {events/cm²-sec}) and growth rate (G (cm/sec}) of crystalline grains, as functions of reciprocal temperature (1/T), in a random crystallization process. For a given reduction in annealing temperature nucleation will proceed slower and, since fewer nuclei are formed, the growth from those that do form will result in larger grains. Since they are thermally activated processes these plots closely follow the Arrhenius Law equation {In(N) = In(Nₒ) - (Q_{N}/kT)}, for nucleation, and {In(G) = In(Gₒ) - (Q_{G}/kT)}, for growth. As the activation energy for nucleation QN is larger than that for growth QG, we can expect a stronger influence on nucleation than on growth upon lowering the anneal temperature, as is illustrated graphically by the plots in Figure 10. By way of example, in a 100nm thick, Si + implanted LPCVD amorphous silicon film, Q_{N} = 3.0 eV and Q_{G} = 1.6 eV. With the annealing temperature lowered from 600 °C to 560 °C, the nucleation rate (N) will decrease by a factor of 6.8, while the growth rate (G) is reduced by a factor of only 2.8. Considering that nucleation density is an areal dimension and we usually measure grain size by an average linear dimension (diameter), we must take the square root of the nucleation rate (2.6x) as an indication of the increase in grain size, up to about 8 micrometers. The correspondingly longer anneal time (2.8x) required for crystallization saturation is still quite practical for implementation.

It should be borne in mind that our method relies upon the use of an amorphous semiconductor film rather than a polycrystalline film as reported in the Noguchi *et al* and Kung *et al* articles, for three important reasons. First, the amorphous film may be practically deposited at a lower temperature (about 580°C) than required for a polycrystalline film (greater than 625°C), a fact that is significant since the higher temperature is only marginally compatible with the preferred low cost glass substrates. Second, as-deposited amorphous film has an extremely smooth surface which is important to maintain high mobility in MOSFET devices which rely upon a surface channel for conduction. A rough surface, as is more typical with as-deposited polycrystalline films, will cause the carriers in a subsequently formed device to scatter when crossing the channel, thus lowering carrier mobility. Third, for a given set of implant conditions, we can control the grain size by varying the annealing temperature. By contrast, the grain size of the recrystallized amorphized polycrystalline films known in the art is predetermined because of their preexisting nuclei.

At first glance there appear to be strong similarities between the implantation of an ion species through the exposed surface of a substrate supported semiconductor film in our invention and in the prior art teachings. This is not the case, because our implantation is performed for an entirely different purpose and therefore is controlled differently. In the known method, the ion implantation step is conducted at a predetermined angle for disrupting the crystal lattice structure of the polycrystalline film in order to convert most of it to an amorphous state. While the directional ion beam destroys most of the crystals it is critical that it leave some nuclei in the film from which grain growth may start as soon as annealing begins. In our invention, we have no grain nuclei to begin with and we effect the ion implantation step in order to provide sufficient energy to "stir up" the interface and to retard the nucleation process. When nucleation does begin, it does so randomly and not from preexisting nuclei.

It should be understood that the present disclosure has been made only by way of example. For example, although we have described our invention with respect to a silicon dioxide substrate, it may be practiced upon a silicon carbide, a silicon nitride, or other suitable substrate. In such cases, after deep ion implantation, carbon or nitrogen or other atoms would recoil across the interface and change the nucleation rate. Similarly, the amorphous semiconductor material may be silicon, germanium, alloys of silicon and germanium, alloys of silicon and carbon, or other suitable material.

## Claims

1. A method of forming large grain polycrystalline films comprising the steps of
providing a substrate of insulating material,
depositing a layer of amorphous semiconductor material upon said substrate to form a composite structure,
implanting a selected ion species into said composite structure at an implant energy and dosage sufficient to disrupt the interface between said amorphous layer and said substrate and thereby retard nucleation when the composite structure is annealed, and
annealing said composite structure so as to cause random nucleation within said amorphous layer and to cause grain growth saturation to form a large grain polycrystalline film.

2. The method of claim 1, wherein the selected ion species is implanted into said composite structure at an implant energy and dosage sufficient to cause the maximum kinetic energy of said implantation to be deposited substantially at said interface.

3. The method of claim 1 or claim 2 wherein said amorphous semiconductor material is elemental and said ion species is of the same element as said amorphous semiconductor material.

4. The method of any preceding claim wherein said amorphous semiconductor material is silicon.

5. The method of any preceding claim wherein said ion species is of a different element than said amorphous semiconductor material in order to dope said semiconductor material.

6. The method of any preceding claim wherein said substrate comprises silicon dioxide and said implanting step causes oxygen to recoil across the interface from said substrate into said amorphous layer.

7. The method of any of claims 1 to 5, wherein said substrate comprises silicon nitride and said implanting step causes nitrogen to recoil across the interface from said substrate into said amorphous layer.

## Patentansprüche

1. Verfahren zur Bildung grobkörniger polykristalliner Filme. umfassend die Schritte des
Schaffens eines Substrats von isolierendem Material,
Abscheidens einer Schicht von amorphem Halbleitermaterial auf dem Substrat zur Bildung einer Verbundstruktur,
Implantierens einer ausgewählten Ionenart in die Verbundstruktur bei einer Implantationsenergie und -dosis, die ausreicht, um die Grenzfläche zwischen der amorphen Schicht und dem Substrat zu zerstören sowie dadurch die Keimbildung zu verzögern, wenn die Verbundstruktur getempert wird, und
Temperns der Verbundstruktur, um die statistische Keimbildung in der amorphen Schicht zu bewirken und zur Bildung eines grobkörnigen polykristallinen Films die Kornwachstumssättigung zu bewirken.

2. Verfahren von Anspruch 1, in dem die ausgewählte Ionenart bei einer Implantationsenergie und -dosis in die Verbundstruktur implantiert wird, die ausreicht, um zu bewirken, daß die maximale kinetische Energie der Implantation im wesentlichen auf die Grenzflache aufgebracht wird.

3. Verfahren von Anspruch 1 oder Anspruch 2, in dem das amorphe Halbleitermaterial elementarisch ist und die Ionenart von dem gleichen Element wie das amorphe Halbleitermaterial ist.

4. Verfahren von irgendeinem vorhergehenden Anspruch, in dem das amorphe Halbleitermaterial Silicium ist.

5. Verfahren von irgendeinem vorhergehenden Anspruch, in dem die Ionenart von einem anderen Element als das Halbleitermaterial ist, um das Halbleitermaterial zu dotieren.

6. Verfahren von irgendeinem vorhergehenden Anspruch, in dem das Substrat Siliciumdioxid umfaßt und der Implantationsschritt bewirkt, daß Sauerstoff durch die Grenzfläche aus dem Substrat in die amorphe Schicht zurückstößt.

7. Verfahren von einem der Ansprüche 1 bis 5, in dem das Substrat Siliciumnitrid umfaßt und der Implantationsschritt bewirkt, daß Stickstoff durch die Grenzfläche aus dem Substrat in die amorphe Schicht zurückstößt.

## Revendications

1. Procédé pour former des couches polycristallines de grains de grandes dimensions comprenant les étapes consistant à :
fournir un substrat d'un matériau isolant,
déposer une couche de matériau semi-conducteur amorphe sur ledit substrat pour former une structure composite,
implanter le type d'ions sélectionné dans la structure composite à une énergie d'implantation et dosage suffisant pour rompre l'interface entre la couche amorphe et le substrat, et retarder de ce fait la nucléation lorsque la structure composite est recuite, et
recuire la structure composite de façon à provoquer une nucléation aléatoire à l'intérieur de la couche amorphe et pour amener la saturation de croissance des grains à former une couche polycristalline à grains de grandes dimensions.

2. Procédé selon la revendication 1, dans lequel les types d'ions sélectionnés sont implantés dans la structure composite à une énergie d'implantation et dosage suffisants pour amener l'énergie cinétique maximale de l'implantation à être déposée pratiquement à l'interface.

3. Procédé selon la revendication 1 ou la revendication 2, dans lequel le matériau semi-conducteur amorphe est élémentaire et le type d'ions est du même élément que le matériau semi-conducteur amorphe.

4. Procédé selon l'une quelconque des revendications précédentes, dans lequel le matériau semi-conducteur amorphe est du silicium.

5. Procédé selon l'une quelconque des revendications précédentes, dans lequel le type d'ions est un élément différent du matériau semi-conducteur amorphe afin de doper le matériau semi-conducteur.

6. Procédé selon l'une quelconque des revendications précédentes, dans lequel le substrat comprend du dioxyde de silicium et l'étape d'implantation amène l'oxygène à être repoussé à travers l'interface à partir du substrat dans la couche amorphe.

7. Procédé selon l'une quelconque des revendications 1 à 5, dans lequel le substrat comprend du nitrure de silicium et une étape d'implantation amène l'azote à être repoussé à travers l'interface à partir du substrat dans la couche amorphe.
